# EUROPEAN PATENT APPLICATION

(11) **EP 1 930 756 A1**
(43) Date of publication of application: **11.06.2008**
(21) Application number: 06767043.0
(22) Date of filing: 21.06.2006
(51) Int. Cl.: G02B 6/122, G02B 6/13, G02B 6/42, H05K 1/02

(54) **OPTICAL WAVEGUIDE DEVICE AND METHOD FOR FABRICATING OPTICAL WAVEGUIDE DEVICE**

(30) Priority: 30.09.2005 JP 2005286663
(71) Applicant: Mitsumi Electric Co., Ltd., Tama-shi, Tokyo 206-8567 (JP)
(72) Inventor: ONO, Tadashi, Tama-shi, Tokyo 2068567 (JP)
(74) Representative: Grünecker, Kinkeldey, Stockmair & Schwanhäusser Anwaltssozietät
(86) International application number: PCT/JP2006/312384
(87) International publication number: WO 2007/039965

(57) **Abstract**

An optical waveguide device in which optical loss is reduced while reducing fabrication cost. Inclining faces (13, 14) of 45° are formed at the opposite ends of an optical guide member (2), and mirrors (15, 16) coated with gold are provided to cover parts of the inclining faces (13, 14) where a core portion (12) is exposed. Gold wiring (17) is provided on the upper surface of the optical guide member (2) to extend along the light guide direction. Using a mask pattern prepared in alignment with the mirrors (15, 16) and the gold wiring (17), the optical guide member (2) is coated with gold by vacuum deposition such as vacuum evaporation or sputtering thus forming the mirrors (15, 16) and the gold wiring (17) simultaneously.

## Description

### Technical Field

The present invention relates to an optical waveguide device and a method for fabricating an optical waveguide device.

### Background Art

Recently, as a component for optical communication, an optical waveguide device which uses polymer resin material is used. In order to change a direction of optical wiring in an optical waveguide, a technique where an end of the optical waveguide forms an inclination surface by 45° and the inclination surface bends an optical path in a right angle is developed (for example, Patent Document 1).

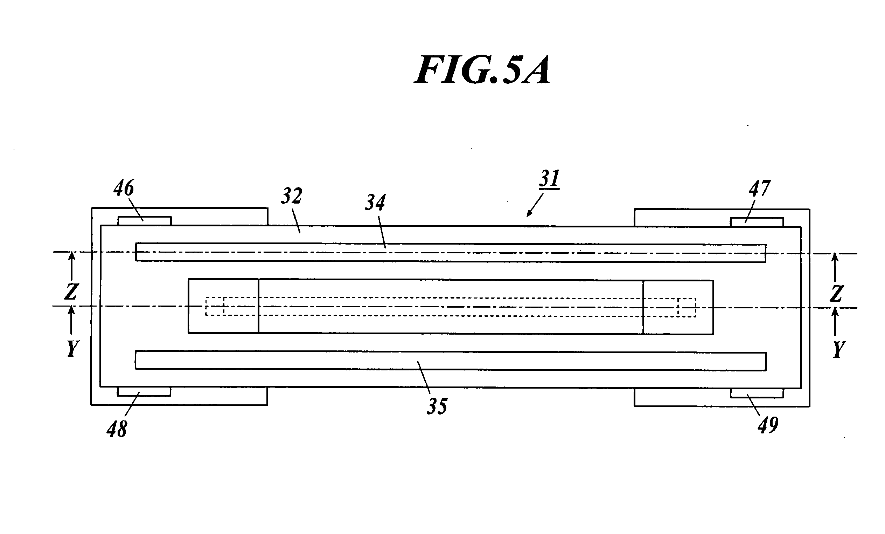

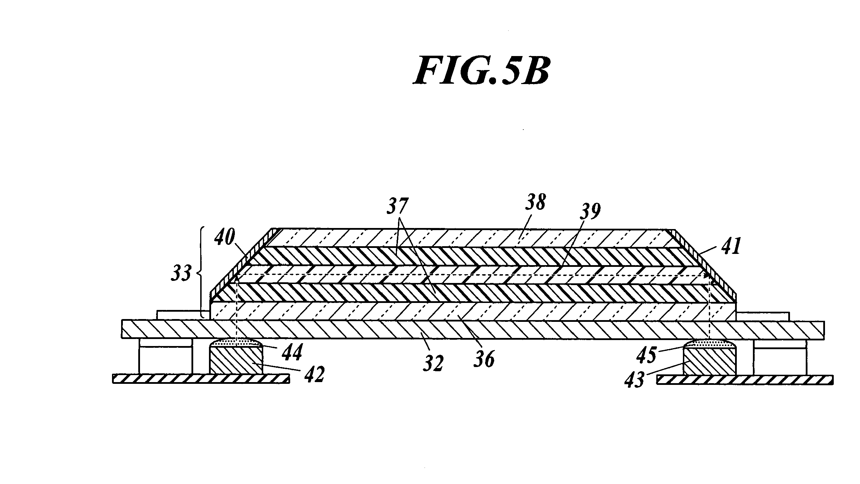

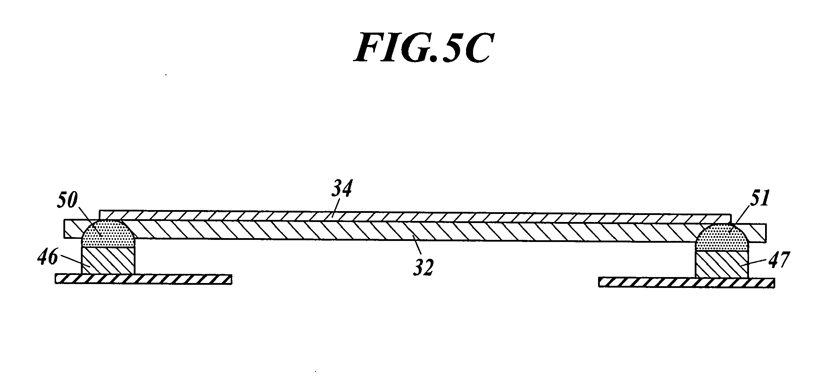

When wiring is provided for electrical connecting along with the optical waveguide, for example a structure in which an optical waveguide and an FPC (Flexible Printed Circuit) provided with copper wiring bonded to each other is possible. An optical waveguide device 31 provided with an optical waveguide and copper wiring is described with reference to FIG. 5A, FIG 5B and FIG. 5C. FIG. 5A is a top view showing the optical waveguide device 31, FIG. 5B is a cross-sectional view showing a cross-section taken along Y-Y of the optical waveguide device 31 shown in FIG. 5A, and FIG. 5C is a cross-sectional view showing a cross-section taken along Z-Z of the optical waveguide device 31 shown in FIG. 5A.

As shown in FIG. 5A, FIG. 5B and FIG. 5C, an optical guide member 33 for guiding light and copper wiring 34, 35 are provided on an electrical wiring film 32 such as polyimide film, etc. Actually, an FPC is constituted with an electrical wiring film which covers a top surface, however, the illustration is omitted.

As shown in FIG. 5B, the optical guide member 33 includes from the bottom a protective layer 36, a clad section 37, and a protective layer 38, and a core section 39 with a refractive index higher than the clad section 37 is formed in the clad section 37. Inclined planes of 45° are formed at the ends of an optical guide member 33, the faces are coated with gold and mirrors 40 and 41 are formed. A light-emitting element 42 and the electrical wiring film 32, and a light-receiving element 43 and the electrical wiring film 32 are adhered with each other by optical path members 44, 45. The light emitted from the light-emitting element 42 is reflected on the mirror 40 and progresses through the core section 39. The light is reflected on the mirror 41 at the other end, and the light is received by the light-receiving element 43.

As shown in FIG. 5A and FIG. 5C, circuit electrodes 46, 47 are electrically connected through connecting members 50, 51 with a copper wiring 34. Circuit electrodes 48, 49 are electrically connected through connecting members (not shown) with a copper wiring 35.
Patent Document 1: Japanese Patent Application Laid-Open Publication No. 2001-166167

### Disclosure of the Invention

### Problems to be Solved by the Invention

However, with the above-described optical waveguide device 31, the electrical wiring film 32 is necessary to provide the copper wiring 34, 35 and light loss due to the electrical wiring film 32 and the adhering material (not shown) for connecting the electrical wiring film 32 and the optical guide member 33 occurred. The optical guide member 33 for performing optical coupling and the copper wiring 34, 35 for performing electrical coupling needed to be provided separately.

The present invention has been made in consideration of the above problems of the techniques, and it is an object to reduce light loss in an optical waveguide device. Another object of the present invention is to reduce fabrication cost.

### Means for Solving the Problem

In order to achieve the above objects, according to a first aspect of the present invention, there is provided an optical waveguide device, comprising:
an optical guide member extending in an optical guide direction with a core section in a clad section, wherein
metallic wiring is provided in the optical guide member.

Preferably, an inclined plane is formed at an end of the optical guide member and the inclined plane is coated with metal, and the metallic wiring includes a same metal as the metal which coats the inclined plane.

Preferably, the metallic wiring is provided on a same side as the metal which coats the inclined plane.

Preferably, the optical guide member is formed in a film-like shape.

Preferably, the metallic wiring extends along the optical guide direction.

Preferably, ends of the optical guide member are provided with photoelectric conversion elements to perform a conversion between light and electricity.

Preferably, one of the photoelectric conversion elements on one end of the optical guide member is a light-emitting element, and the other of the photoelectric conversion elements on the other end is a light-receiving element.

According to a second aspect of the present invention, there is provided a method for fabricating an optical waveguide device comprising an optical guide member extending in an optical guide direction with a core section in a clad section, comprising:
forming metallic wiring in the optical guide member.

According to a third aspect of the present invention, a method for fabricating an optical waveguide device comprising:
forming an inclined plane at the end of an optical guide member extending in an optical guide direction with a core section in a clad section;
coating a metal on the inclined plane; and
forming metallic wiring in the optical guide member simultaneously with coating the metal on the inclined plane.

### Advantageous Effect of the Invention

According to the present invention, since an electrical wiring film for separately providing an electrical wiring is not necessary, scattering and reflecting on an interface may be avoided, and optical loss may be reduced. Since the structure is simple, the cost may be reduced and occurrence of breakdown may be reduced.

### Brief Description of the Drawings

FIG. 1A is a top view showing an optical waveguide film cable 1 of the embodiment of the present invention;
FIG. 1B is a cross-sectional view showing a cross-section taken along X-X of the optical waveguide film cable 1 shown in FIG. 1A;
FIG. 2A is a diagram for describing a forming of the lower clad layer 10a;
FIG. 2B is a diagram for describing a forming of the core layer 19;
FIG. 2C is a diagram for describing a forming of the core section 12;
FIG. 3A is a diagram for describing a forming of the upper clad layer 10b;
FIG. 3B is a diagram for describing a forming of the inclined planes 13, 14;
FIG. 4 is a diagram for describing a method of forming mirrors 15, 16 and gold wiring 17, 18;
FIG. 5A is a top view showing an optical waveguide device 31;
FIG. 5B is a cross-sectional view showing a cross-section taken along Y-Y of the optical waveguide device 31 shown in FIG. 5A; and
FIG. 5C is a cross-sectional view showing a cross-section taken along Z-Z of the optical waveguide device 31 shown in FIG. 5A.

### Best Mode for Carrying Out the Invention

An embodiment of the present invention will be specifically described with reference to the drawings.

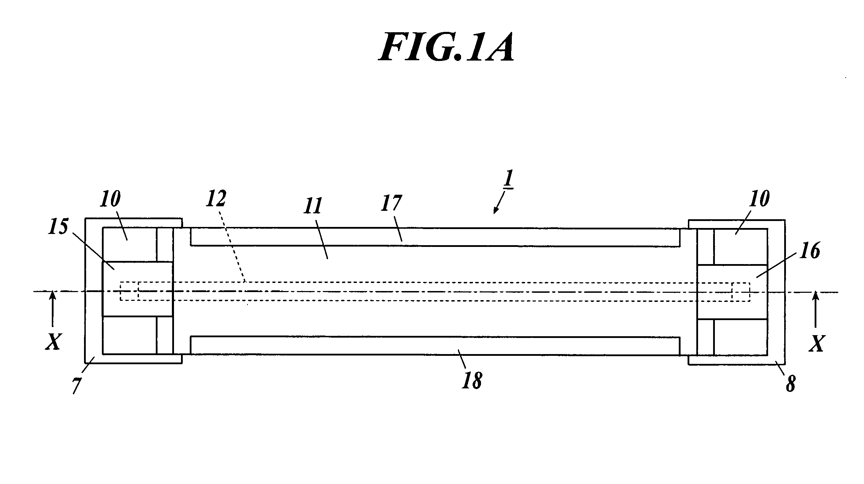

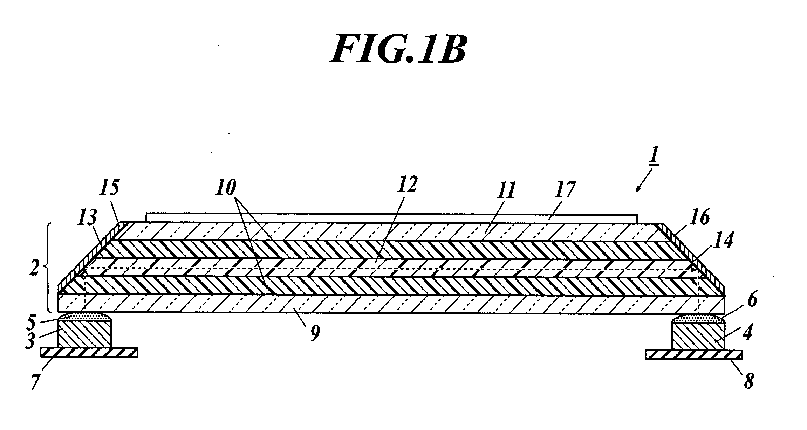

FIG. 1A is a top view showing an optical waveguide film cable 1 of the embodiment and FIG. 1B is a cross-sectional view showing a cross section taken along X-X of the optical waveguide film cable 1 shown in FIG. 1A.

As shown in FIG. 1A and FIG. 1B, the optical waveguide film cable 1 is constituted of an optical guide member 2 extending in an optical guide direction (In FIG. 1B, a right direction), a light-emitting element 3 provided on one of the ends of the optical guide member 2, a light-receiving element 4 provided on the end opposite of the light-emitting element 3, and the like. The light-emitting element 3 and the optical guide member 2, and the light-receiving element 4 and the optical guide member 2 are adhered with each other by optical path members 5, 6. The optical path members 5, 6 have a function to adhere and fix the light-emitting element 3 and the light-receiving element 4 to the optical guide member 2 and a function as a refractive medium to stabilize transmission of light.

The light-emitting element 3 is constituted of, for example, surface emitting semiconductor laser (VCSEL: Vertical Cavity Surface Emitting Laser), and according to an electrical signal supplied externally, emits light in a direction perpendicular to the contact face with the optical guide member 2 (in FIG. 1B, upward). The light-emitting element 3 is provided on a substrate 7.

The light-receiving element 4 is constituted of, for example, PD (PhotoDiode) and receives light in a direction perpendicular to the contact face with the optical guide member 2 (in FIG. 1B, downward) to convert to an electrical signal. The light-receiving element 4 is provided on a substrate 8.

The optical guide member 2 has a film-like shape and flexibility. The optical guide member 2 is constituted of, from the bottom, a clad layer 9, a core section 10 and a protective layer 11 and a core section 12 with a higher refractive index than the clad section 10 is formed in the clad section 10.

As shown in FIG. 1B, inclined planes 13, 14 of 45° are formed at the ends of the optical guide member 2, and mirrors 15, 16 coated with gold are provided to cover portions of the inclined planes 13, 14 where the core section 12 is exposed. On the same side as the mirrors 15, 16 of the optical guide member 2, gold wiring 17, 18 extending along the optical guide direction are provided. Here, the same side as the mirrors 15, 16 means the upper surface of the optical guide member 2 shown in FIG. 1B.

As shown in FIG. 1B, light emitted from the light-emitting element 3 is reflected on a mirror 15 and subjected to optical path change by 90°. The light propagates through the core section 12, is reflected on the mirror 16, and received by the light-receiving element 4.

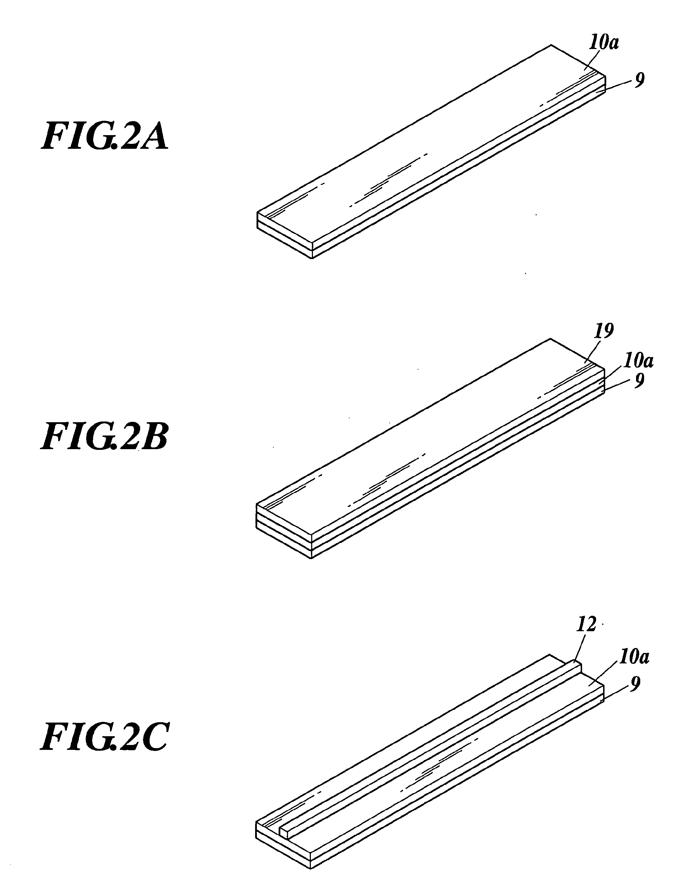

Next a method for fabricating an optical waveguide film cable 1 is described, with reference to FIG. 2A, FIG. 2B, FIG. 2C, FIG. 3A, FIG. 3B and FIG. 4.

First, as shown in FIG. 2A, a resin thin film in a liquid state is formed on the protective film 9 with a rotating film formation method, etc., and the film is heated to form a lower clad layer 10a. The protective film 9 is constituted of resin film, for example, polyimide, PET, etc. The lower clad layer 10a includes polymeric resin material with optical transparency, and is constituted of, for example, epoxy resin, acrylic resin, imide resin, etc.

Then, as shown in FIG. 2B, a resin thin film in a liquid state is formed on the lower clad layer 10a with a rotating film formation method, etc., and the film is heated to form a core layer 19 with a higher refractive index than the lower clad layer 10a. The core layer 19 includes polymeric resin material with optical transparency and is constituted of, for example, epoxy resin, acrylic resin, imide resin, etc. Next, a mask is applied to the core layer 19, and as shown in FIG. 2C, the core section 12 is formed with photolithography and etching processing.

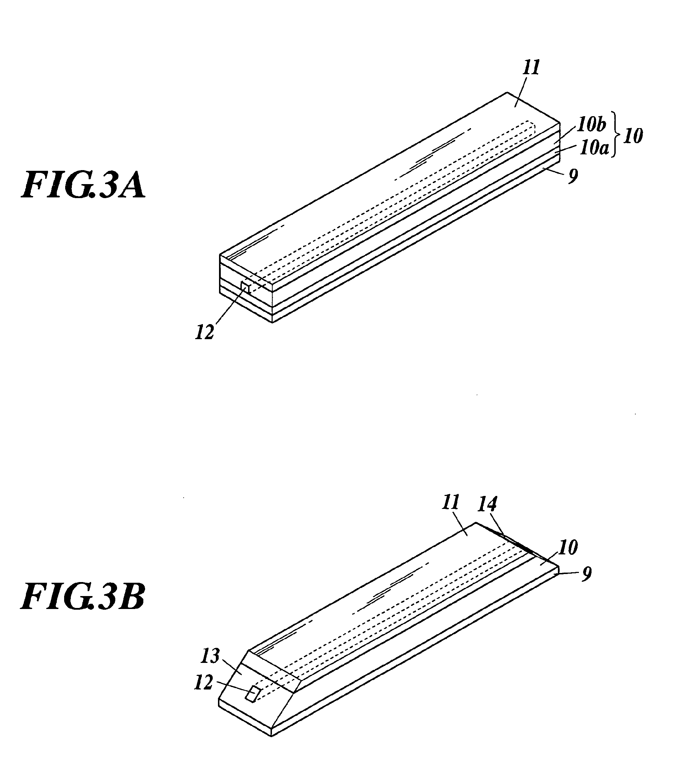

Next, as shown in FIG. 3A, a resin thin film in a liquid state is formed with a rotating film formation method, etc., and the film is heated to cover the core section 12 with a material which includes the same composition as the lower clad layer 10a to form an upper clad layer 10b. A protective film 11 is formed on the upper clad layer 10b. The protective film 11 is constituted of a resin film, for example, polyimide, PET, etc. The lower clad layer 10a and the upper clad layer 10b correspond to the clad section 10 shown in FIG. 1A and FIG. 1B.

Next, as shown in FIG. 3B, the ends of the layers shown in FIG. 3A are cut at 45° to form inclined planes 13, 14 and form the optical guide member 2 before being coated with gold.

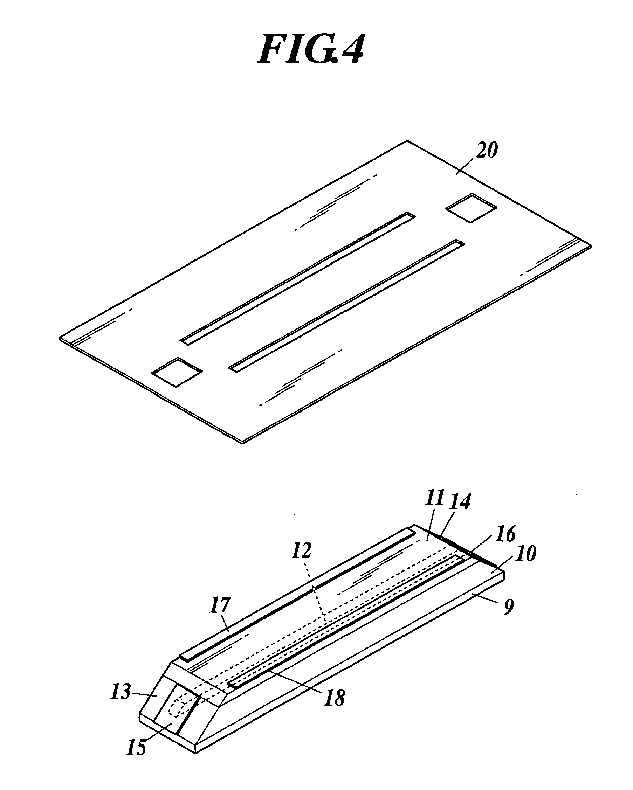

Next, as shown in FIG. 4, using a mask pattern 20 prepared in accordance with the position of the mirrors 15, 16 and the gold wiring 17, the optical guide member 2 is coated with gold by vacuum deposition such as vacuum evaporation, sputtering, etc., thus forming the mirrors 15, 16 and the gold wiring 17 simultaneously. The mirrors 15, 16 with a film thickness of about 0.3 µm is enough for practical use. It is preferable that the gold wiring 17, 18 are a thickness of about 3 µm.

As shown in FIG. 1B, the light-emitting element 3 and the light-receiving element 4 are adhered to the optical guide member 2 with the optical path members 5, 6, and the optical waveguide film cable 1 is completed.

As described above, according to the present embodiment, since an electrical wiring film for separately providing an electrical wiring is not necessary, scattering and reflecting on an interface may be avoided, and optical loss may be reduced. The mirrors 15, 16 and the gold wiring 17, 18 are formed simultaneously, thus compared to forming the mirrors 15, 16 and the gold wiring 17, 18 separately, a number of steps in the fabricating process may be reduced. Since the structure is simple, the cost may be reduced and occurrence of breakdown may be reduced.

The above-described embodiment is an example of the optical waveguide device of the present invention, and thus is not limited to the embodiments shown. Details of the components constituting the optical waveguide film cable 1 may be modified without leaving the scope of the invention.

For example, in the above-described embodiment, in FIG. 1B, the gold wiring 17, 18 are formed on a top surface of the optical guide member 2, however, the wiring may be provided on a side surface or a bottom surface of the optical guide member 2. In the above-described embodiment, the gold wiring 17, 18 are formed on a top surface of the protective layer 11, however, the wiring may be directly provided on the clad section 10.

When the optical guide member 2 is coated with gold, a plurality of mask patterns may be used together. Instead of the vacuum deposition, electrolytic plating or nonelectrolytic plating may be used. Instead of coating with gold, an activated metal such as Cr/Cu, Cr/Al, etc. may be put in between, and a base metal conductor may be placed.

In the above-described embodiment, the angle of the mirror faces 15, 16 are formed at 45°, however, the angle of the mirror faces 15, 16 are not limited to this angle, and the angle may be adjusted to an angle so that the light loss becomes a minimum according to a characteristic of the light-emitting element 3 or the light-receiving element 4.

In the above-described embodiment, the light-emitting element 3 and the light-receiving element 4 are respectively provided on different substrates 7, 8, however, the light-emitting element 3 and the light-receiving element 4 may be provided on the same substrate.

### Industrial Applicability

The optical waveguide device and the method for fabricating the optical waveguide device of the present invention are useful in the field of optical communication and may be applied to a technique which performs optical coupling and electrical coupling.

### Description of Reference Numerals

- 1: optical waveguide film cable (optical waveguide device)
- 2: optical guide member
- 3: light-emitting element
- 4: light-receiving element
- 5, 6: optical path members
- 9: protective layer
- 10: clad section
- 10a: lower clad layer
- 10b: upper clad layer
- 11: protective layer
- 12: core section
- 13, 14: inclined planes
- 15, 16: mirrors
- 17, 18: metallic wiring
- 19: core layer
- 20: mask pattern
- 31: optical waveguide device
- 32: electrical wiring film
- 33: optical guide member
- 34, 35: copper wiring
- 36: protective layer
- 37: clad section
- 38: protective layer
- 39: core section
- 40, 41: mirrors
- 42: light-emitting element
- 43: light-receiving element
- 44, 45: optical path members
- 46, 47, 48, 49: circuit electrodes

## Claims

1. An optical waveguide device, comprising:
an optical guide member extending in an optical guide direction with a core section in a clad section, wherein
metallic wiring is provided in the optical guide member.

2. The optical waveguide device according to claim 1, wherein an inclined plane is formed at an end of the optical guide member and the inclined plane is coated with metal, and the metallic wiring includes a same metal as the metal which coats the inclined plane.

3. The optical waveguide device according to claim 2, wherein the metallic wiring is provided on a same side as the metal which coats the inclined plane.

4. The optical waveguide device according to any one of claims 1 to 3, wherein the optical guide member is formed in a film-like shape.

5. The optical waveguide device according to any one of claims 1 to 4, wherein the metallic wiring extends along the optical guide direction.

6. The optical waveguide device according to any one of claims 1 to 5, wherein ends of the optical guide member are provided with photoelectric conversion elements to perform a conversion between light and electricity.

7. The optical waveguide device according to claim 6, wherein one of the photoelectric conversion elements on one end of the optical guide member is a light-emitting element, and the other of the photoelectric conversion elements on the other end is a light-receiving element.

8. A method for fabricating an optical waveguide device comprising an optical guide member extending in an optical guide direction with a core section in a clad section, comprising:
forming metallic wiring in the optical guide member.

9. A method for fabricating an optical waveguide device comprising:
forming an inclined plane at the end of an optical guide member extending in an optical guide direction with a core section in a clad section;
coating a metal on the inclined plane; and
forming metallic wiring in the optical guide member simultaneously with coating the metal on the inclined plane.
